# EUROPÄISCHE PATENTSCHRIFT

(11) **EP 2 933 358 B1**
(45) Veröffentlichungstag und Bekanntmachung des Hinweises auf die Patenterteilung: **24.08.2016**
(21) Anmeldenummer: 15162204.0
(22) Anmeldetag: 01.04.2015
(51) Int. Cl.: C30B 13/08, C30B 29/06, C30B 13/20, C30B 11/00, C30B 13/14, C30B 11/10

(54) **VORRICHTUNG UND VERFAHREN ZUR HERSTELLUNG EINES EINKRISTALLS AUS SILIZIUM**
APPARATUS AND PROCESS FOR PRODUCING A SINGLE CRYSTAL OF SILICON
APPAREIL ET PROCÉDÉ POUR PRÉPARER UN MONOCRISTAL DE SILICIUM

(30) Priorität: 14.04.2014 DE 102014207149
(43) Veröffentlichungstag der Anmeldung: 21.10.2015
(73) Patentinhaber: Siltronic AG, 81737 München (DE)
(72) Erfinder: Brenninger, Georg, 84564 Oberbergkirchen (DE); Stein, Waldemar, 84489 Burghausen (DE); Häberlen, Maik, 84489 Burghausen (DE)

(56) Entgegenhaltungen:
- EP-A1- 2 319 961
- EP-A1- 2 354 278
- US-A1- 2003 145 781

## Beschreibung

Gegenstand der Erfindung ist eine Vorrichtung und ein Verfahren zur Herstellung eines Einkristalls aus Silizium, mit der körniges Silizium als Rohmaterial zu einem Einkristall verarbeitet werden kann. Die Vorrichtung umfasst einen Teller mit einer zentralen Öffnung und einem Rohr, das von der zentralen Öffnung nach unten gerichtet ist, eine Einrichtung zum Dosieren des körnigen Siliziums auf den Teller, eine erste Induktionsheizspule, die über dem Teller angeordnet ist und eine zweite Induktionsheizspule, die unter dem Teller angeordnet ist.

In der US2003145781 A1 und der US2011185963 A1 sind Vorrichtungen mit den genannten Merkmalen beschrieben und auch Verfahren zur Herstellung eines Einkristalls unter Verwendung derartigen Vorrichtungen. Das Rohr, das an seinem unteren Ende zunächst mit festem Silizium geschlossen ist, wird mit Hilfe der zweiten Induktionsheizspule erhitzt, damit sich auf der Unterseite des verschlossenen Rohrs flüssiges Silizium bildet. Anschließend wird ein einkristalliner Keimkristall mit dem flüssigen Silizium in Kontakt gebracht, gedreht und abgesenkt und gleichzeitig weiteres Silizium von der Unterseite des Rohrs geschmolzen. Beim Absenken des Keimkristalls kristallisiert flüssiges Silizium auf dem Keimkristall. Nach einer Phase, die Einschnürung (necking) genannt wird und dem Zweck dient, Versetzungen aus dem kristallisierten Teil zu dessen Oberfläche zu leiten, liegt schließlich ein wachsender Einkristall vor. Auf der Stirnseite des wachsenden Einkristalls befindet sich ein kleines Volumen einer Schmelze aus Silizium, die das weitere Wachstum des Einkristalls unterhält. Das Volumen der Schmelze und der Durchmesser des wachsenden Einkristalls werden während einer weiteren Phase stetig vergrößert bis ein Zieldurchmesser erreicht ist. Danach lässt man den Einkristall annähernd zylindrisch wachsen, um den zylindrisch gewachsenen Teil später zu Halbleiterscheiben weiterzuverarbeiten. Nachdem das feste Silizium, das das untere Ende des Rohrs verschlossen hat, geschmolzen ist, wird weiteres flüssiges Silizium, das zum Wachstum des Einkristalls benötigt wird, bereitgestellt. Hierzu wird körniges Silizium auf dem Teller abgelegt und mit Hilfe der ersten Induktionsheizspule und unter Drehen des Tellers geschmolzen. Es gelangt als flüssiges Silizium von der Oberseite des Tellers zur zentralen Öffnung im Teller und durch das Rohr zur Schmelze auf dem wachsenden Einkristall.

In der US2003145781 A1 wird vorgeschlagen, einen Behälter aus Quarz oder eine Platte aus Silizium als Teller zu verwenden und auf der Oberseite des Tellers Erhebungen vorzusehen, die Durchgänge bilden, um den Weg für das schmelzende Silizium bis zur zentralen Öffnung zu verlängern. Die Wegverlängerung soll unterstützen, dass vom körnigen Silizium stammendes festes Silizium vollständig geschmolzen ist, bevor es zum wachsenden Einkristall gelangt. Für den Fall, dass auf solche Durchgänge verzichtet wird, wird vorgeschlagen, durch Einwirkung der ersten Induktionsheizspule eine Barriere aus festem Silizium auf der Oberseite des Tellers im Bereich der zentralen Öffnung zu errichten. Die Höhe der Barriere wird derart gewählt, dass körniges Silizium die Barriere nicht überwinden kann, solange es nicht vollständig geschmolzen ist.

Die Erfinder der vorliegenden Erfindung haben festgestellt, dass sich die Oberseite eines Tellers aus Silizium durch Einwirken der ersten Induktionsheizspule derart verändert, dass die Verwendung des Tellers zur Herstellung eines weiteren Einkristalls nicht in Betracht kommt oder nur nach aufwändiger Überholung möglich ist. Des Weiteren wurde festgestellt, dass bei Verwendung eines Tellers aus Quarz der Transport von flüssigem Silizium vom Bereich des äußeren Rands der Oberseite zum inneren Rand der Oberseite beeinträchtigt ist, selbst dann, wenn Durchgänge zur Wegverlängerung fehlen.

Aufgabe der vorliegenden Erfindung ist es, eine einfache Wiederverwendbarkeit des Tellers zu ermöglichen und den Transport von flüssigem Silizium vom äußeren Rand der Oberseite des Tellers zum inneren Rand der Oberseite des Tellers zu erleichtern.

Gelöst wird die Aufgabe durch eine Vorrichtung zur Herstellung eines Einkristalls aus Silizium, umfassend
einen Teller mit einer Oberseite, die einen äußeren Rand und einen inneren Rand aufweist, mit einer zentralen Öffnung, die an den inneren Rand angrenzt, und mit einem Rohr, das sich von der zentralen Öffnung bis unterhalb einer Rückseite des Tellers erstreckt;
eine Einrichtung zum Dosieren von körnigem Silizium auf die Oberseite des Tellers; eine erste Induktionsheizspule, die über dem Teller angeordnet und zum Schmelzen des abgelegten körnigen Siliziums vorgesehen ist;
eine zweite Induktionsheizspule, die unter dem Teller angeordnet und zum Stabilisieren einer Schmelze aus Silizium vorgesehen ist, wobei sich die Schmelze auf einem wachsenden Einkristall aus Silizium befindet, dadurch gekennzeichnet, dass die Oberseite des Tellers aus keramischem Material besteht und Erhebungen und zwischen den Erhebungen Täler aufweist, wobei der Abstand zwischen den Mitten benachbarter Erhebungen in radialer Richtung nicht weniger als 2 mm und nicht mehr als 15 mm ist und der Höhenunterschied zwischen einem Talgrund und dem höchsten Punkt einer das Tal begrenzenden Erhebung nicht weniger als 0,1 mm und nicht mehr als 5 mm beträgt.

Gegenstand der Erfindung ist auch ein Verfahren zur Herstellung eines Einkristalls aus Silizium, umfassend das Bereitstellen der genannten Vorrichtung;
das Ablegen von körnigem Silizium auf der Oberseite des Tellers im Bereich des äußeren Rands der Oberseite unter Drehen des Tellers;
das Schmelzen des körnigen Siliziums und das Leiten des geschmolzenen Siliziums über die Erhebungen hinweg durch die zentrale Öffnung im Teller und durch das Rohr bis zur Schmelze auf dem wachsenden Einkristall aus Silizium.

Der Teller und das Rohr sind vorzugsweise aus einem Stück. Die Oberseite des Tellers besteht aus einem keramischen Material, das beim Kontakt mit flüssigem Silizium temperaturbeständig ist und das flüssiges Silizium möglichst wenig durch Fremdstoffe verunreinigt. Der Teller und das Rohr können aus einem Grundkörper bestehen, der mit dem keramischen Material beschichtet ist. Der Teller und das Rohr können auch vollständig aus dem keramischen Material bestehen. Mögliche Werkstoffe für den Grundkörper sind bruchfeste und hochtemperaturbeständige Werkstoffe, die sich mit dem keramischen Material beschichten lassen, beispielsweise Metalle und Kohlenstoff. Besonders bevorzugt sind Grundkörper aus Kohlenstoff. Das keramische Material ist bevorzugt ein Material wie Aluminiumoxid (Al₂O₃), Bornitrid (BN), Lanthanhexaborid (LaB₆), Siliziumcarbid (SiC), Siliziumnitrid (Si₃N₄), Yttriumoxid (Y₂O₃), Zirkoniumoxid (ZrO₂) oder Quarz (SiO₂). Besonders bevorzugt ist Siliziumcarbid.

Wegen der Erhebungen ist die Oberseite des Tellers nicht eben, sondern strukturiert. Zwischen den Erhebungen befinden sich Täler, vorzugsweise geschlossene Täler. Geschlossene Täler sind Flächen auf der Oberseite des Tellers, die von Erhebungen vollständig umschlossen sind. Flüssiges Silizium, das sich in einem der Täler befindet, bildet einen See, der durch die Erhebungen eingeschlossen ist. Derartige Erhebungen sind zwischen dem äußeren und dem inneren Rand der Oberseite des Tellers verteilt. Die Täler können einen Grundriss haben, der beispielsweise ringförmig, quadratisch, rechteckig, spiralförmig oder rautenförmig ist. Zwischen Tälern am äußeren Rand des Tellers und Tälern, die radial näher zur zentralen Öffnung im Teller liegen, besteht vorzugsweise ein Gefälle. Das Gefälle hat einen Neigungswinkel von vorzugsweise nicht weniger als 1° und nicht mehr als 15°, besonders bevorzugt nicht weniger als 1° und nicht mehr als 5°. Flüssiges Silizium neigt daher, vom äußeren Rand des Tellers zur zentralen Öffnung im Teller zu fließen.

Die Erfinder haben herausgefunden, dass die Erhebungen zweckmäßig sind, um den Transport von flüssigem Silizium vom äußeren Rand der Oberseite des Tellers zum inneren Rand der Oberseite des Tellers zu erleichtern. Fehlen die Erhebungen, ist der Transport von flüssigem Silizium zur zentralen Öffnung beeinträchtigt. Der Grund dafür ist die mäßige Benetzbarkeit des keramischen Materials durch flüssiges Silizium. Auf einem Teller ohne Erhebungen entstehen träge Inseln aus flüssigem Silizium, die die Oberseite des Tellers nur spärlich benetzen und kaum Neigung zeigen, zur zentralen Öffnung zu fließen.

Durch die erfindungsgemäß vorgeschlagene Strukturierung der Oberseite des Tellers durch Erhebungen bilden sich beim Schmelzen des abgelegten körnigen Siliziums in den Tälern Seen aus flüssigem Silizium. Mit der Zeit steigt das Volumen solcher Seen an, bis die Erhebungen flüssiges Silizium nicht mehr in den Tälern halten können und die Seen überlaufen. Das überlaufende flüssige Silizium zeigt keine Neigung zur Inselbildung und fließt schließlich über die Erhebungen hinweg zur zentralen Öffnung im Teller. Dabei vereinigt sich überlaufendes flüssiges Silizium und bedeckt großflächig die Oberseite des Tellers.

Der Höhenunterschied zwischen einem Talgrund und dem höchsten Punkt einer das Tal begrenzenden Erhebung ist nicht weniger als 0,1 mm und nicht mehr als 5 mm, besonders bevorzugt nicht weniger als 0,5 mm und nicht mehr als 3 mm. Um den Stofftransport an flüssigem Silizium über die Erhebungen hinweg zu ermöglichen, ist der Abstand zwischen den Mitten benachbarter Erhebungen in radialer Richtung nicht weniger als 2 mm und nicht mehr als 15 mm, vorzugsweise nicht weniger als 3 mm und nicht mehr als 6 mm.

Die erfindungsgemäße Vorrichtung hat den zusätzlichen Vorteil, dass auf eine Kühleinrichtung verzichtet werden kann, die benötigt würde, um den Teller zu kühlen, bestünde er aus Silizium. Die erfindungsgemäße Vorrichtung kommt ohne eine solche Kühleinrichtung aus.

Gemäß einer besonders bevorzugten Ausführungsform der Erfindung formen die Erhebungen und die Täler in Draufsicht Ringe, die um die zentrale Öffnung konzentrisch angeordnet sind. Darüber hinaus können die Erhebungen und Täler auch auf der inneren Oberfläche des Rohrs vorhanden sein.

Der äußere Rand der Oberseite des Tellers kann von einer Wand umschlossen sein, aufgrund derer der Teller auch als Schale bezeichnet werden könnte.

Die Erfindung wird nachfolgend an Hand von Figuren erläutert.

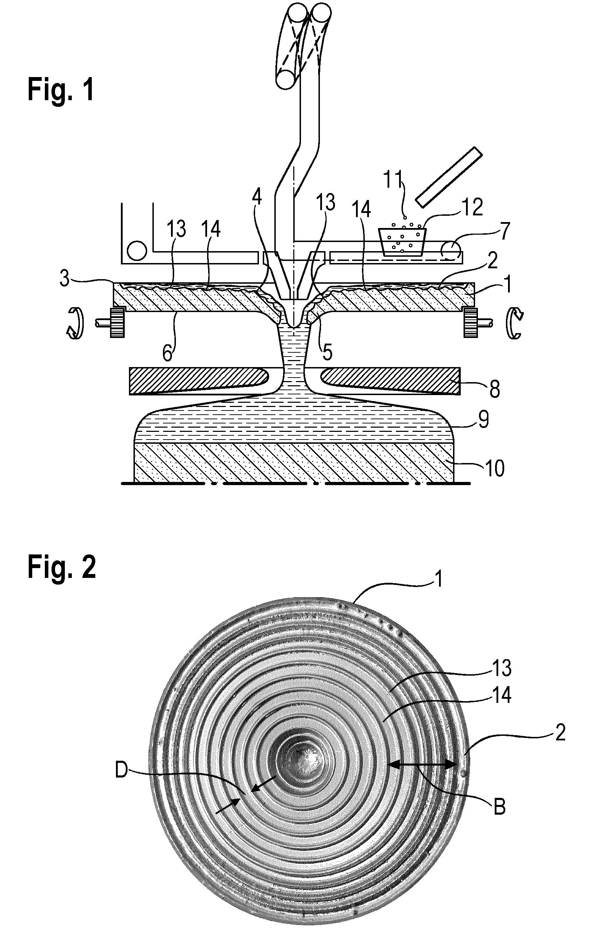

Fig. 1 zeigt die Schnittdarstellung einer besonders bevorzugten Ausführungsform der erfindungsgemäßen Vorrichtung zur Herstellung eines Einkristalls aus Silizium.

Die Vorrichtung gemäß Fig.1 umfasst einen Teller 1 mit einer Oberseite 2, die einen äußeren Rand 3 und einen inneren Rand 4 aufweist. In der Mitte des Tellers befinden sich eine zentrale Öffnung, die an den inneren Rand angrenzt, und ein Rohr 5, das sich von der zentralen Öffnung bis unterhalb einer Rückseite des Tellers 6 erstreckt. Die Vorrichtung umfasst ferner eine erste Induktionsheizspule 7, die über dem Teller angeordnet ist und eine zweite Induktionsheizspule 8, die unter dem Teller angeordnet ist. Die erste Induktionsheizspule 7 wird zum Schmelzen von körnigem Silizium eingesetzt und die untere Induktionsheizspule 8 zum Stabilisieren einer Schmelze 9 aus Silizium, die sich auf einem wachsenden Einkristall 10 aus Silizium befindet. Das körnige Silizium 11 wird mittels einer Dosier-Einrichtung 12 durch die erste Induktionsheizspule 7 zur Oberseite des Tellers gebracht, beispielsweise gestreut. Es wird vorzugsweise derart zugeführt, dass es mit der Oberseite des Tellers erstmalig in einem äußeren Bereich nahe dem äußeren Rand in Kontakt kommt.

Der Oberseite des Tellers besteht aus keramischem Material, vorzugsweise aus Siliziumcarbid und weist Erhebungen 13 auf, die geschlossene Täler 14 begrenzen. Die Erhebungen 13 und geschlossenen Täler 14 formen in Draufsicht Ringe, die konzentrisch zur zentralen Öffnung liegen und die sich vom äußeren Rand bis zum inneren Rand der Oberseite des Tellers erstrecken und die auch auf der inneren Oberfläche des Rohrs vorhanden sind.

Fig.2 zeigt den Teller 1 mit den zur zentralen Öffnung konzentrisch liegenden ringförmigen Erhebungen 13 und Tälern 14 in Draufsicht. Der Abstand D zwischen den Mitten benachbarter Erhebungen beträgt in radialer Richtung nicht weniger als 2 mm und nicht mehr als 15 mm. Der Bereich B auf der Oberseite 2 des Tellers 1, in den das körnige Silizium gebracht wird, hat beispielsweise die durch den Doppelpfeil angezeigte radiale Lage und Breite.

### Beispiel und Vergleichsbeispiel:

Zur Herstellung von Einkristallen aus Silizium wurden zwei unterschiedliche Vorrichtungen bereitgestellt. Der einzige Unterschied bestand darin, dass zur Herstellung auf nicht erfindungsgemäße Weise eine Vorrichtung mit einem Teller verwendet wurde, auf dessen Oberseite keine Erhebungen waren. Zur Herstellung auf erfindungsgemäße Weise wurde eine erfindungsgemäße Vorrichtung eingesetzt, mit einem Teller gemäß Fig.2, auf dessen Oberseite konzentrisch liegende ringförmige Erhebungen vorhanden waren.

Es stellte sich heraus, dass der Massetransport an flüssigem Silizium bei Verwendung des Tellers mit glatter unstrukturierter Oberseite wegen der Bildung träger Inseln flüssigen Siliziums erheblich beeinträchtigt war. Bei Verwendung der erfindungsgemäßen Vorrichtung trat dieser Nachteil nicht auf.

## Patentansprüche

1. Vorrichtung zur Herstellung eines Einkristalls aus Silizium, umfassend
einen Teller (1) mit einer Oberseite (2), die einen äußeren Rand (3) und einen inneren Rand (4) aufweist, mit einer zentralen Öffnung, die an den inneren Rand (4) angrenzt, und mit einem Rohr (5), das sich von der zentralen Öffnung bis unterhalb einer Rückseite (6) des Tellers (1) erstreckt;
eine Einrichtung zum Dosieren von körnigem Silizium (11) auf die Oberseite (2) des Tellers (1) ;
eine erste Induktionsheizspule (7), die über dem Teller (1) angeordnet und zum Schmelzen des abgelegten körnigen Siliziums (11) vorgesehen ist;
eine zweite Induktionsheizspule (8), die unter dem Teller (1) angeordnet und zum Stabilisieren einer Schmelze (9) aus Silizium vorgesehen ist, wobei sich die Schmelze (9) auf einem wachsenden Einkristall (10) aus Silizium befindet, **dadurch gekennzeichnet, dass**
die Oberseite (2) des Tellers (1) aus keramischem Material besteht und Erhebungen (13) und zwischen den Erhebungen (13) Täler (14) aufweist, wobei der Abstand zwischen den Mitten benachbarter Erhebungen (13) in radialer Richtung nicht weniger als 2 mm und nicht mehr als 15 mm ist und der Höhenunterschied zwischen einem Talgrund und dem höchsten Punkt einer das Tal begrenzenden Erhebung nicht weniger als 0,1 mm und nicht mehr als 5 mm beträgt.

2. Vorrichtung nach Anspruch 1, **dadurch gekennzeichnet, dass** das keramische Material ausgewählt ist aus einer Gruppe, die Aluminiumoxid, Bornitrid, Lanthanhexaborid, Siliziumcarbid, Siliziumnitrid, Tantaloxid, Yttriumoxid, Zirkoniumoxid und Quarz umfasst.

3. Vorrichtung nach Anspruch 1 oder Anspruch 2, **dadurch gekennzeichnet, dass** die Erhebungen (13) konzentrisch um die zentrale Öffnung angeordnet sind.

4. Vorrichtung nach einem der Ansprüche 1 bis 3, **dadurch gekennzeichnet, dass** der äußere Rand (3) der Oberseite (2) des Tellers (1) von einer Wand umschlossen ist.

5. Verfahren zur Herstellung eines Einkristalls aus Silizium, umfassend
das Bereitstellen der Vorrichtung nach einem der Ansprüche 1 bis 4;
das Ablegen von körnigem Silizium (11) auf der Oberseite (2) des Tellers (1) im Bereich des äußeren Rands (3) der Oberseite (2) unter Drehen des Tellers (1);
das Schmelzen des körnigen Siliziums (11) und das Leiten des geschmolzenen Siliziums über die Erhebungen (13) hinweg durch die zentrale Öffnung im Teller (1) und durch das Rohr (5) bis zu einer Schmelze (9) auf einem wachsenden Einkristall (10) aus Silizium.

## Claims

1. Apparatus for producing a single crystal of silicon, comprising
a plate (1) with a top side (2) having an outer edge (3) and an inner edge (4), with a central opening adjoining the inner edge (4), and with a tube (5) which extends from the central opening to beneath a bottom side (6) of the plate (1);
a device for metering granular silicon (11) onto the top side (2) of the plate (1);
a first induction heating coil (7) which is arranged above the plate (1) and is provided for melting of the granular silicon (11) deposited;
a second induction heating coil (8) which is arranged beneath the plate (1) and is provided for stabilization of a melt (9) of silicon, the melt (9) being present upon a growing single crystal (10) of silicon, **characterized in that** the top side (2) of the plate (1) consists of ceramic material and has elevations (13) and valleys (14) between the elevations (13), the distance between the middles of adjacent elevations (13) in radial direction being not less than 2 mm and not more than 15 mm and the difference in height between a valley floor and the highest point of an elevation which bounds the valley being not less than 0.1 mm and not more than 5 mm.

2. Apparatus according to Claim 1, **characterized in that** the ceramic material is selected from the group comprising alumina, boron nitride, lanthanum hexaboride, silicon carbide, silicon nitride, tantalum oxide, yttria, zirconia and quartz.

3. Apparatus according to Claim 1 or Claim 2, **characterized in that** the elevations (13) are arranged concentrically about the central opening.

4. Apparatus according to any of Claims 1 to 3, **characterized in that** the outer edge (3) of the top side (2) of the plate (1) is surrounded by a wall.

5. Process for producing a single crystal of silicon, comprising
the providing of the apparatus according to any of Claims 1 to 4;
the depositing of granular silicon (11) on the top side (2) of the plate (1) in the region of the outer edge (3) of the top side (2) while rotating the plate (1); the melting of the granular silicon (11) and the passing of the molten silicon over the elevations (13) through the central opening in the plate (1) and through the tube (5) until it is a melt (9) upon a growing single crystal (10) of silicon.

## Revendications

1. Dispositif pour la fabrication d'un monocristal en silicium, comprenant
une plaque (1) avec une face supérieure (2), laquelle présente un bord extérieur (3) et un bord intérieur (4), avec une ouverture centrale qui jouxte le bord intérieur (4), et avec une conduite (5) qui s'étend de l'ouverture centrale jusqu'en-dessous d'une face arrière (6) de la plaque (1) ;
un dispositif pour le dosage de silicium granulaire (11) sur la face supérieure (2) de la plaque (1) ;
une première bobine de chauffage par induction (7), laquelle est disposée au-dessus de la plaque (1) et est prévue pour faire fondre le silicium granulaire (11) déposé ;
une deuxième bobine de chauffage par induction (8) qui est disposée sous la plaque (1) et est prévue pour la stabilisation d'une masse fondue (9) en silicium, la masse fondue (9) se trouvant sur un monocristal en silicium (10) en croissance,
**caractérisé en ce que**
la face supérieure (2) de la plaque (1) se compose d'un matériau en céramique et présente des bosses (13) et des creux (14) entre les bosses (13), la distance entre les centres de bosses (13) voisines en direction radiale n'étant pas inférieure à 2 mm et pas supérieure à 15 mm et la différence de hauteur entre un fond d'un creux et le point le plus élevé d'une bosse délimitant le creux n'étant pas inférieure à 0,1 mm et pas supérieure à 5 mm.

2. Dispositif selon la revendication 1, **caractérisé en ce que** le matériau en céramique est sélectionné dans un groupe comprenant de l'oxyde d'aluminium, du nitrure de bore, de l'hexaborure de lanthane, du carbure de silicium, du nitrure de silicium, de l'oxyde de tantale, de l'oxyde d'yttrium, de l'oxyde de zirconium et du quartz.

3. Dispositif selon la revendication 1 ou la revendication 2, **caractérisé en ce que** les bosses (13) sont disposées de manière concentrique autour de l'ouverture centrale.

4. Dispositif selon l'une des revendications 1 à 3, **caractérisé en ce que** le bord extérieur (3) de la face supérieure (2) de la plaque (1) est entouré par une paroi.

5. Procédé pour la fabrication d'un monocristal en silicium, comprenant :
la mise à disposition du dispositif selon l'une des revendications 1 à 4 ;
le dépôt de silicium granulaire (11) sur la face supérieure (2) de la plaque (1) dans la zone du bord extérieur (3) de la face supérieure (2) en faisant tourner la plaque (1) ;
la fonte du silicium granulaire (11) et le guidage du silicium fondu par-delà les bosses (13) à travers l'ouverture centrale dans la plaque (1) et à travers la conduite (5) jusqu'à une masse fondue (9) sur un monocristal en silicium (10) en croissance.
